# DEMANDE DE BREVET EUROPEEN

(11) **EP 4 149 232 A1**
(43) Date de publication de la demande: **15.03.2023**
(21) Numéro de dépôt: 22205821.6
(22) Date de dépôt: 18.02.2020
(51) Int. Cl.: H10K 39/32

(54) **DISPOSITIF MATRICIEL POUR CAPTEUR D'IMAGE, A TRANSISTORS EN COUCHES MINCES ET PHOTODIODES ORGANIQUES**

(30) Priorité: 25.02.2019 FR 1901899
(62) Demande divisionnaire de: 20704548.5
(71) Demandeur: ISORG, 87068 Limoges Cedex 3 (FR)
(72) Inventeur: BALLOT, Noémie, 38040 GRENOBLE CEDEX 09 (FR); BLANCHON, David, 38040 GRENOBLE CEDEX 09 (FR); FEI, Richun, 38040 GRENOBLE CEDEX 09 (FR)
(74) Mandataire: Cabinet Beaumont

(57) **Abrégé**

L'invention concerne un dispositif électrooptique pour capteur d'image matriciel, à transistors Ts en couches minces et détecteurs organiques qui intègre un circuit 20 de pilotage de lignes, à transistors Tg en couches minces dans une zone périphérique ZP. On prévoit un écran de lumière sur le niveau topologique 201 porté par la couche diélectrique 105 au-dessus des transistors en couches minces, qui sont des écrans individuels LS_{i,j}, pour chaque pixel dans la zone de matrice 10, et un écran global LS_{GOA} pour tous les transistors Tg du circuit de pilotage. L'écran global LS_{GOA} en zone périphérique sert en outre de structure d'interconnexion pour polariser l'électrode supérieure E2 des photodiodes organiques de la zone active, à la tension de polarisation Vbias, par un recouvrement en contact direct. Dans la zone active, le niveau 203 d'électrode supérieure E2 est séparé du niveau 201 d'électrode pixel E1 par la structure active organique OST. Dans la zone périphérique, on retrouve ces deux niveaux topologiques 201 et 203, sont formés directement l'un sur l'autre, sans interposition.

## Description

La présente invention concerne un dispositif optoélectronique, à matrice de détection basée sur des transistors en couches minces et des photodiodes organiques, dits OPD (*"Organic PhotoDiodes"*), pour réaliser un capteur matriciel d'image (ou imageur pixélisé).

L'invention s'applique notamment, mais pas exclusivement, aux capteurs d'image utilisés pour le contrôle d'accès (services, biens, aéroports, etc.). Si on prend le domaine des capteurs d'empreinte (d'un doigt ou de la paume d'une main), il s'agit de prendre une image du dessin papillaire correspondant à l'alternance des creux et crêtes présents sur l'épiderme en surface de la peau. Le processus de prise d'image est le suivant : on appose ou on présente l'objet dont on veut prendre une image (un doigt par exemple) dans une fenêtre de détection du capteur. Une prise d'image se déclenche (de manière automatique, par détection ou sur commande, par exemple par un bouton déclencheur). Cela provoque l'éclairement de l'objet, par une source d'éclairage intégrée au capteur (par exemple une source de lumière blanche (leds) intégrée sur un côté, associée à une optique de focalisation, ou un tapis de diodes électroluminescentes placé entre la surface de détection et l'objet) . Et le capteur mesure en chaque pixel la quantité de lumière réfléchie par l'objet dans sa direction pendant une période d'intégration déterminée. Cette quantité est plus ou moins importante selon qu'elle est réfléchie par une zone de crête ou de sillon de l'épiderme. Après cette phase d'intégration, suit une phase de lecture des pixels, qui a pour but de convertir les quantités de charges intégrées par chacun des pixels, en valeurs numériques correspondant à des niveaux de gris. On obtient une image numérisée de l'objet, prête à être utilisée/traitée par des algorithmes propres à l'application en cause. S'agissant d'une empreinte, il s'agira de comparer les données d'empreinte obtenues à des données de référence.

Les capteurs d'image à base de photodiodes organiques associées à des transistors à couches minces TFT sont des bons candidats pour couvrir le large panel des applications possibles, et sont en plein essor. Ces capteurs sont en effet peu coûteux, fiables et rapides, mais également fins, légers et robustes, permettant leur intégration aisée sur tout type de support transparent ou non, rigide aussi bien que souple, dans tout type d'environnement applicatif, comme par exemple, sur le volant d'un véhicule, une carte bancaire, un téléphone portable, un ordinateur, un poste de contrôle (aéroport).

Dans ces capteurs, la matrice de détection consiste en un empilement vertical d'une matrice de photodiodes organiques assurant la fonction de détection de lumière (conversion de photons en charges électriques) sur une matrice de transistors à couches minces, assurant la fonction électronique de commande permettant de piloter et lire les pixels. On parle de matrice active ou passive selon qu'elle utilise plusieurs transistors ou un seul, par pixel. Dans la suite on utilise simplement le terme matrice active, étant entendu que cela couvre les deux possibilités.

Les matrices actives basées sur des transistors en couches minces, ou plus simplement transistors TFT (Thin Film Transistor), se sont largement développées pour la commande de pixels d'affichage (LCD, OLED) et les technologies associées se sont perfectionnées avec la demande croissante d'écrans d'affichage toujours plus grands et performants. Différentes technologies de transistors TFT sont ainsi disponibles, qui ont été développées pour réduire leurs coûts, améliorer leurs performances électriques (consommation, vitesse de commutation, stabilité), leur encombrement (miniaturisation), permettre l'utilisation de substrats supports bien moins coûteux que le silicium, et pouvant être aussi bien rigides que flexibles, etc. Ces technologies se différencient notamment par le matériau semi-conducteur de canal : silicium amorphe (a-SI:H), Oxyde d'indium-Gallium-Zinc (IGZO), organique (OTFT), ou encore silicium polycristallin basse température (LTPS). Différentes topologies sont également proposées : planaires, étagées à grille dessus ("*staggered structure*") ou étagées à grille dessous ("*inverse staggered structure").*

Les capteurs d'image ont bénéficié de ces progrès technologiques et intègrent de telles matrices actives à transistors TFT pour la commande des pixels de détection dans les capteurs d'image. Il s'agit alors de gérer la prise d'image et permettre la lecture des pixels.

Lorsque la matrice comprend un seul transistor par pixel (matrice passive), elle permet simplement de sélectionner un pixel pour transmettre les charges collectées par le pixel pendant la durée d'exposition à la lumière, à une circuiterie électronique de lecture. Lorsque la matrice comprend d'autres transistors en plus de ce transistor de sélection (matrice active), elle permet une commande électronique des pixels plus perfectionnée et notamment réinitialiser les pixels, empêcher leur saturation, appliquer des techniques de lecture plus perfectionnées dans le but d'améliorer le rapport signal sur bruit. En particulier, un transistor monté en suiveur est prévu qui assure une conversion charges/tension à l'intérieur du pixel, et le transistor de sélection transmet alors vers l'électronique de lecture, un niveau de signal représentatif des charges collectées. Pour des applications telles que la capture d'empreinte, une matrice à un transistor par pixel, plus compacte et moins coûteuse sera généralement suffisante et dans la suite de la description, nous nous plaçons dans ce contexte. Néanmoins tout ce qui va être dit par la suite s'applique aussi bien à une matrice qui comporterait plus d'un transistor par pixel.

Dans l'invention, on s'intéresse aux aspects topologiques d'un capteur d'image formé par superposition d'une matrice organique de détection de lumière sur une telle matrice de transistors TFT, dans le but d'améliorer sa compacité et ses performances électriques y compris sa résistance aux décharges électrostatiques, contribuant à sa fiabilité et ses qualités optiques. Avant d'expliquer les aspects topologiques de cet empilement permettant d'expliquer la problématique en question, il convient de rappeler brièvement le schéma électrique d'un capteur matriciel d'image.

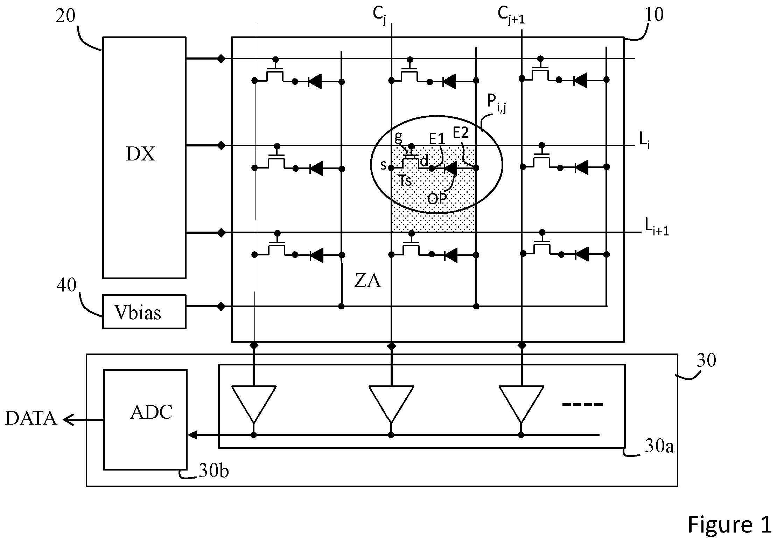

La figure 1 représente les éléments structurels principaux d'un capteur d'image : une matrice active de détection 10, un circuit de pilotage 20 des lignes de la matrice et un circuit de lecture 30 des cellules de la matrice.

La matrice 10 est formée de pixels tous identiques, disposés en lignes et colonnes. Le pixel P_{i,j} situé sur la ligne de rang i et la colonne de rang j de la matrice, comprend un transistor de sélection Ts dont la grille est reliée à un conducteur ligne Lᵢ reliant les grilles des transistors de sélection de tous les pixels de la ligne de rang i ; et dont une électrode terminale de drain ou source, par exemple la source s, est reliée à un conducteur colonne Cⱼ reliant les sources des transistors de sélection de tous les pixels de la colonne de rang j. L'autre électrode terminale, le drain d, est reliée à l'électrode pixel E1, qui dans l'exemple illustré correspond à la cathode de la photodiode OP. L'autre électrode E2 de photodiode, l'anode dans l'exemple, est polarisée à une tension de polarisation Vbias qui est la même pour tous les pixels de la matrice : c'est pour cela que dans la figure, toutes les électrodes E2 sont reliées en commun par des conducteurs à un bus d'alimentation qui reçoit la tension de polarisation Vbias.

En pratique, cette électrode E2 est formée sur le dernier niveau de l'empilement des couches de photodiodes, en une structure de couche continue (et/ou d'un maillage) couvrant la surface de matrice, et elle est polarisée à la tension de polarisation, généralement par une interconnexion à un bus périphérique longeant au moins un côté de la matrice. La tension de polarisation est appliquée sur ce bus par des plots de reprise de contact prévus en bord de dalle, permettant une connexion par nappe flexible à une source d'alimentation externe.

On notera que la surface de détection de lumière du pixel s'inscrit dans le rectangle hachuré sur la figure, délimité par les deux conducteurs colonnes Cⱼ et Cⱼ₊₁ et les deux conducteurs lignes Lᵢ et Lᵢ₊₁.

Le circuit de pilotage 20 permet la sélection séquentielle (on parle aussi de balayage) de chaque ligne de pixels, l'une après l'autre, dans chaque période de capture. De manière bien connue, la sélection d'une ligne de pixels de détection de la matrice correspond à l'application sur le conducteur ligne correspondant d'une impulsion de tension de commande de grille, qui permet la commutation à l'état passant, le temps de l'impulsion, des transistors Ts des pixels de la ligne sélectionnée. Le circuit de lecture 30 peut alors lire ces pixels, chacun via le conducteur colonne associé : dans chaque pixel sélectionné, les électrons issus des photons reçus par le pixel et collectés par la cathode sont transférés via le transistor de sélection qui est passant, sur le conducteur colonne associé. Ce conducteur colonne est relié à une entrée correspondante du circuit de lecture 30, qui comprend de manière classique un étage amplificateur 30a suivi d'un convertisseur analogique numérique 30b. Les données numériques en sortie du convertisseur sont transmises à un système de traitement d'image (non représenté). Lorsque le pixel comprend plusieurs transistors, le transistor de sélection n'est plus relié directement à l'électrode pixel, mais indirectement par un transistor qui assure une conversion courant/tension. Mais le principe d'adressage en lecture reste similaire.

Le circuit de pilotage 20 est basé sur une structure de registre(s) à décalage, avec autant d'étages de sorties que de lignes de matrice qui permettent la sélection et la lecture des pixels, ligne par ligne. De manière bien connue et décrite dans la littérature technique, un schéma électrique correspondant comprend des arrangements de transistors et de capacités, notamment des capacités dites de bootstrap, et ces éléments électroniques sont pilotés à haute fréquence pour permettre la propagation d'une impulsion de haute tension d'un étage de sortie à un autre. Ces arrangements sont conçus pour permettre de piloter à haute fréquence des lignes en sortie (les conducteurs lignes) qui sont fortement capacitives.

Ces circuits de pilotage ou drivers lignes ont longtemps été réalisés en technologie CMOS. C'était donc des circuits périphériques externes, raccordés par nappes flexibles sur des plots de reprise de contact de la dalle de matrice de détection. Avec les progrès techniques, on a pu proposer des schémas performants de drivers lignes basés sur des transistors TFT (et des capacités). Ces drivers lignes intégrés sont généralement désignés dans la littérature par le terme anglais "Gate On Array" (ou son acronyme GOA). L'interconnexion avec les conducteurs lignes (et les aspects de fiabilité associés) est plus optimale (compacité, coût, fiabilité). Notamment on réduit significativement le nombre de points de reprise de contact sur la dalle de composant à prévoir pour les connexions/interfaces externes. On réduit également les coûts de fabrication car les transistors TFT réalisant le circuit de pilotage 20 (GOA) et la matrice active 10 sont alors réalisés collectivement dans la même étape technologique sur le même substrat. La sortie de chaque étage de sortie du registre à décalage est formée dans l'alignement et connectée à un conducteur ligne correspondant de la matrice. Cette intégration est en ligne avec la demande du marché de toujours plus de compacité et fiabilité, à moindre coût.

L'invention concerne un tel composant optronique intégrant sur la même dalle de composant la matrice de détection et le circuit de pilotage des lignes de matrice de détection et un objet de l'invention est une conception optimisée d'un tel composant, pour une fiabilité et une compacité plus grandes, sans dégradation du coût de fabrication, prenant en compte les différentes problématiques de connectiques, de perturbations électriques ou lumineuses présentes.

En particulier, on sait bien que la lumière altère/modifie les propriétés électriques du matériau semi-conducteur de canal des transistors TFT. Plus précisément, l'exposition à la lumière entraîne une dérive de tension de seuil conduisant à des non-uniformités de comportement des transistors de commutation de la matrice, certains devenant moins passants, voire plus du tout passants du fait d'une tension de seuil qui devient plus élevée. Cela a pour effet de dégrader la qualité d'image fournie en sortie, et donc la fiabilité du capteur : le taux d'erreur associé à l'application en cause va augmenter (empreinte non reconnue). Cela altère aussi la durée de vie des capteurs. Cette problématique concerne l'ensemble des transistors TFT intégrés sur la dalle de composant, c'est-à-dire aussi bien les transistors de la matrice active, que ceux du circuit de pilotage.

On connait des techniques électroniques (solutions dynamiques) pour compenser ces variations de tension de seuil en augmentant le niveau des tensions de commande, mais c'est très coûteux (solutions dynamiques).

Une autre solution, passive, est de faire en sorte que les canaux des transistors soient protégés de la lumière, par un écran. La grille des transistors TFT, qui de manière conventionnelle est réalisée dans un métal opaque (argent, molybdène, cuivre ...), peut dans certains cas remplir cette fonction d'écran lorsque la lumière arrive par la grille (avant d'arriver sur le canal). Cette solution est dépendante de la topologie des transistors (grille dessus ou dessous) et du mode d'éclairage et de la position de l'objet à imager, par la face avant et/ou la face arrière du capteur. Elle est aussi dépendante des techniques de fabrication et de la technologie des transistors TFT : dans certains cas, la grille peut ne pas protéger suffisamment le canal au niveau des bords, en sorte que la protection ne sera pas toujours optimale. Ceci concerne plus particulièrement le cas où la grille est réalisée en dernier, après le canal et les électrodes de source/drain (structure étagée à grille dessus).

Il est donc généralement nécessaire d'intégrer un élément spécifique dans l'empilement de couches du composant pour remplir cette fonction d'écran, en prenant soin de ne pas gêner ou de façon insignifiante, la transmission de lumière utile et/ou d'éclairage vers la structure active de détection. En d'autres termes il ne faut pas réduire, ou le moins possible, le taux d'ouverture du pixel.

Il faut ainsi tenir compte des spécifications du capteur d'image (cahier des charges) auquel est destiné le composant optronique, pour déterminer comment intégrer ces écrans. En effet, on peut avoir des conditions différentes d'un capteur à l'autre : la lumière utile à détecter arrive généralement sous incidence normale par l'électrode supérieure, transparente, des photodiodes organiques, par la face avant du capteur. Mais elle peut arriver par la face arrière de substrat support (nécessairement transparent dans ce cas) voire à la fois par la face avant ou la face arrière dans des capteurs offrant les deux possibilités. Pour la source d'éclairage de l'objet à imager : dans certains capteurs, elle est intégrée, par exemple dans un logement, en face avant ou en face arrière. Dans d'autres capteurs, la source d'éclairage est intégrée dans la topologie même du composant (sur un niveau topologique de l'empilement), en face arrière ou en face avant (tapis de diodes organiques OLED utilisées en éclairage).

Il faut également prendre en compte la technologie même des transistors TFT, et notamment si ils sont à grille dessus ou dessous.

Comme indiqué précédemment, cette problématique de protection des canaux de transistors TFT vis à vis de la lumière concerne aussi bien les transistors de la matrice de détection que ceux du circuit de pilotage. Pour ces derniers, ce problème peut cependant être résolu avec l'intégration dans le capteur de destination, quand une plaque d'encapsulation en matériau opaque avec une fenêtre transparente de détection correspondant à la zone utile (active) à exposer à la lumière est prévue.

Mais tout ceci ne prend en compte que les sources de lumière dans les conditions d'utilisation du capteur en opérationnel. Or, si on a indiqué que le procédé de fabrication des photodiodes organiques par voie liquide et à faible budget thermique, est compatible avec les technologies des transistors TFT, on s'est cependant rendu compte qu'au cours de la fabrication de la matrice organique par-dessus l'empilement topologique TFT, des rayonnements, notamment les rayonnements UV utilisés, n'étaient pas sans influence sur les caractéristiques électriques des TFT. En d'autres termes, en mesurant les caractéristiques électriques des transistors TFT réalisés sur une dalle, avant et après la réalisation de la matrice organique, on observe des variations. Et ceci peut aussi bien toucher les transistors TFT de matrice active que ceux du circuit de pilotage.

Un objet de l'invention est de proposer un composant superposant une matrice de photodétection organique par-dessus une matrice de transistors TFT qui par conception protège efficacement tous les transistors TFT situés dans le même niveau topologique de dalle, des rayonnements utilisés lors du processus d'empilement de matrice organique et des rayonnements présents en opérationnel, quelles que soient la technologie ou le type de ces transistors et les spécificités de détection et d'éclairage du capteur d'image concerné. On réduit ainsi efficacement les disparités entre les caractéristiques électriques des transistors du composant, contribuant à améliorer les performances du capteur (fiabilité, durée de vie).

Dans l'invention, on souhaite faire cela sans dégrader la compacité du composant, et de préférence en l'améliorant, pour satisfaire la demande du marché de capteurs toujours plus petits et plus fins, permettant leur intégration aisée, et de capteurs résistants à la manipulation. La taille du composant est conditionnée par le nombre et l'épaisseur des couches de l'empilement ; mais aussi par la surface de zone périphérique à prévoir autour de la matrice (pour une taille donnée d'imageur), pour réaliser ou connecter les éléments électriques et électroniques nécessaires pour piloter la matrice de pixels.

On a déjà expliqué supra qu'il était avantageux d'intégrer le circuit 20 de pilotage des lignes dans cette zone périphérique. Mais dans cette zone périphérique, on doit aussi placer les points de reprise de contact permettant les connexions à la circuiterie électronique de lecture, qui est généralement externe (circuit CMOS), ainsi qu'un bus conducteur métallique pour assurer la polarisation d'électrode supérieure E2. Cette polarisation d'électrode doit pouvoir garantir la plus grande uniformité de courant de surface pour que la conversion photoélectrique dans les pixels et la lecture soit la plus homogène possible sur toute la surface de matrice assurant une bonne qualité d'image. Aussi, généralement, on prévoit que le bus longe deux côtés de la matrice, depuis un bord de dalle sur lequel sont prévus des points de reprise de contact pour la connexion (par nappe flexible typiquement) à une source de polarisation externe ; et la plaque d'électrode déborde de la matrice sur ces deux côtés pour réaliser la connexion sur ce bus, par recouvrement (contact direct) ou par interconnexions verticales (vias).

### Résumé de l'invention

Un objet de l'invention est de répondre à ces diverses problématiques de fiabilité, performances et compacité, par une solution facile à implémenter et peu coûteuse, indépendante des technologies TFT utilisées et des spécificités fonctionnelles des capteurs.

Un dispositif optoélectronique matriciel pour capteur d'image selon l'invention, comporte sur un même substrat support isolant une matrice de pixels alignés en lignes et colonnes, réalisée dans une zone active de détection et un circuit de pilotage à transistors pour la commande des lignes de pixels, réalisé dans une zone périphérique, chaque pixel comportant au moins un transistor qui a une fonction de transistor de sélection du pixel, et une photodiode organique entre une électrode inférieure propre au pixel et connectée au dit au moins un transistor de pixel, et une électrode supérieure commune aux pixels, et le dispositif optoélectronique étant réalisé par un empilement d'ensembles de couches successifs sur le substrat diélectrique support qui comprend :
- dans la zone de matrice active :
   - un premier ensemble de couches minces de transistors réalisant lesdits au moins un transistor des pixels, recouvert par une couche de passivation, isolante, s'étendant de manière continue sur ledit premier ensemble, et
   - un deuxième ensemble de couches réalisant les photodiodes organiques des pixels et comprenant un premier niveau d'empilement de couche(s) conductrice(s) qui est un niveau localisé spatialement, porté par ladite couche de passivation, réalisant l'électrode inférieure dans chaque pixel, un deuxième niveau d'empilement de couche(s) de structure organique active et un troisième niveau d'empilement de couche(s) conductrices réalisant l'électrode supérieure des pixels s'étendant au-dessus de la structure active, et dans chaque pixel, ledit premier niveau d'empilement de couche(s) conductrices réalisant également dans chaque pixel un écran de lumière couvrant au moins la surface de transistor(s) du pixel, et
- dans la zone périphérique :
   - ledit premier ensemble de couches qui réalise lesdits transistors du circuit de pilotage,
   - le premier niveau d'empilement de couche(s) conductrice(s) localisé spatialement porté par ladite couche de passivation, qui réalise un écran de lumière qui s'étend de manière continue au-dessus desdits transistors du circuit de pilotage, et comporte une zone de reprise de contact permettant une connexion à une tension de polarisation externe,
   - l'électrode supérieure des pixels s'étend dans la zone périphérique pour recouvrir en contact électrique direct ledit écran de lumière, formant une interconnexion de polarisation de l'électrode supérieure à la tension Vbias.

Selon un premier aspect, le premier niveau d'empilement de couche(s) localisé comprend au moins une couche conductrice en métal opaque qui est spatialement localisée pour former les motifs d'écran de lumière dans la zone active et dans la zone périphérique.

Avantageusement, le premier niveau d'empilement comprend au moins une deuxième couche en matériau conducteur transparent qui forme la surface supérieure dudit premier niveau d'empilement.

Selon un autre aspect, le premier niveau d'empilement forme des motifs bicouches en surface de couche de passivation, comportant un motif opaque réalisé dans le plan de surface de la couche de passivation, et un motif transparent qui recouvre et déborde de chaque côté dudit motif opaque sur la couche de passivation.

Dans une variante, le premier niveau d'empilement forme des motifs tri-couches en surface de couche de passivation, qui comportent un motif opaque entièrement encapsulé dans l'épaisseur d'un motif transparent.

D'autres caractéristiques, détails et avantages de l'invention ressortiront à la lecture de la description suivante, faite en référence aux dessins annexés à titre d'exemple et qui représentent respectivement :
- la figure 1 : un schéma-bloc général d'un circuit de matrice active de détection optique et des circuits périphériques d'adressage et de lecture, selon l'état de l'art, dans un exemple de structure de pixel comportant un transistor TFT et une photodiode utilisée en structure inverse.
- la figure 2 : un schéma simplifié en vue de dessus d'un dispositif optoélectronique selon l'invention.
- la figure 3 : une vue de dessus, correspondant à un mode de réalisation de l'invention.
- la figure 4 : une vue en coupe schématique des empilements (niveaux/couches) topologiques d'un dispositif selon l'invention dans un mode de réalisation plus particulièrement adapté à un éclairage et une détection de lumière par la face avant, dans un exemple de structure monocouche d'électrode pixel en métal opaque.
- la figure 5 : une variante de la figure 4, utilisant une structure multicouche d'électrode pixel dans une version "globalement" opaque.
- la figure 6 : une variante de la figure 5, illustrant une version "globalement transparente".

### Description détaillée

Par souci de clarté, dans les figures, les mêmes éléments sont désignés par les mêmes références. Egalement, seuls les éléments utiles à la compréhension de l'invention ont été détaillés. Il est également utile de préciser que dans la présente description, les termes "connecté", "interconnecté", "connexion" ou "interconnexion" désignent une connexion directe entre deux éléments conducteurs, sans interposition de composant électronique ; et les termes "relié" ou "couplé" ou "raccordé" désignent une liaison électrique directe ou via un composant électronique tel que par exemple, un transistor. Par ailleurs, les figures ont été dessinées pour faciliter la compréhension de l'invention. Notamment les différents éléments des dessins ne sont pas à l'échelle et seuls les éléments utiles à la compréhension de l'invention sont représentés.

On a vu que la figure 1 montre une matrice 10 de pixels de détection et les circuits périphériques de pilotage 20, de lecture 30 et de polarisation 40. Les pixels sont chacun formés d'une photodiode organique OP et d'au moins un transistor TFT noté Ts qui permet la sélection du pixel par une sortie respective du circuit de pilotage 20. La photodiode organique a une électrode inférieure E1 qui forme l'électrode pixel et une électrode supérieure E2 qui en pratique est une électrode commune à tous les pixels. Dans l'exemple la photodiode organique est utilisée en structure inverse : E1 correspond à la cathode (injection d'électrons) et E2 à l'anode (injection de trous), qui est alors polarisée à une tension Vbias négative ou nulle.

L'invention est expliquée pour une telle utilisation de photodiode en structure inverse, mais s'applique aussi bien à une structure utilisée en direct (dans ce cas E2 correspondrait à la cathode et la tension Vbias serait une tension positive).

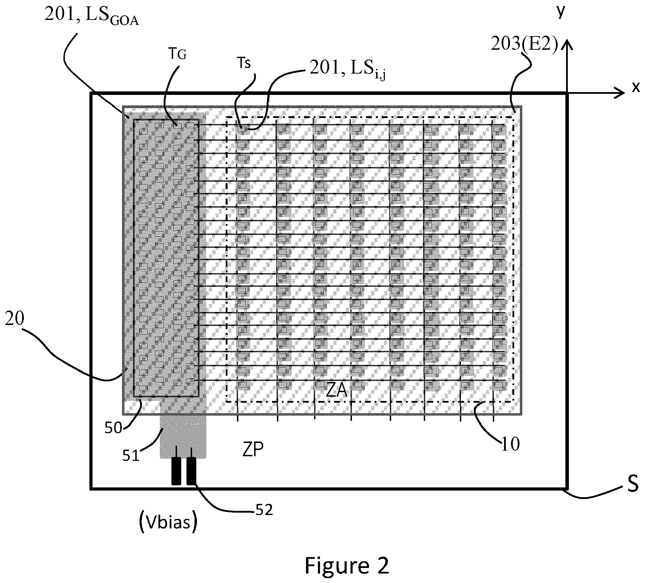

Dans un dispositif optoélectronique selon l'invention et comme représenté en figure 2, la matrice 10 de détection et le circuit de pilotage 20 sont réalisés sur une même dalle de composant. La matrice est réalisée dans une zone dite active ZA (délimitée en pointillé) en surface supérieure d'un substrat support S. Le terme "active" se rapporte aussi bien à la matrice active de transistors TFT (qu'il y ait un ou plus de transistors par pixels), qu'à la fonction de photogénération de charges électriques dans la structure organique active des pixels. Le circuit de pilotage 20 est réalisé en zone périphérique ZP, à l'extérieur de la zone active, sur un côté de la matrice active dans le prolongement des conducteurs lignes qu'il doit piloter. Les transistors TFT sont figurés par des petits rectangles sur la figure. Dans la zone active, ils sont figurés à raison d'un rectangle par pixel, régulièrement alignés selon les colonnes et les lignes de la matrice, correspondant à l'exemple de structure de pixel décrite, à un seul transistor Ts, de sélection. Pour le circuit de pilotage 20, on a représenté une disposition régulière d'ensembles de rectangles figurant des transistors Tg des différents étages de registre à décalage. Cette figure n'est qu'indicative de la constitution des pixels et du circuit de pilotage, pour aider à la compréhension de l'invention.

La réalisation du dispositif est obtenue de manière usuelle, par un empilement de couches successives. Certaines couches de l'empilement sont spatialement localisées en utilisant des masques, pour former des éléments isolés les uns des autres dans la zone active et/ou la zone périphérique, et c'est notamment le cas des couches formant les transistors TFT (Ts, T_{GOA}) et les électrodes pixels E1.

La structure active organique entre les deux électrodes est présente dans la zone active uniquement, et peut être réalisée sous forme continue (non localisée "*unpatterned*") dans cette zone comme illustré. Mais elle pourrait aussi être formée en éléments actifs individuels ("*patterned*")*.* Elle comprend en mélange ou en juxtaposition des matériaux polymères semi-conducteurs donneurs et accepteurs, formant la jonction PN, et une couche d'amélioration de l'injection de charges, au moins entre la jonction et l'électrode qui sert de cathode (E1 dans l'exemple). Ces aspects sont bien connus de l'homme de l'art et ne seront pas détaillés, l'invention ne portant pas sur la structure organique elle-même.

Dans la suite, on utilise le terme "niveau topologique" pour désigner la ou les couches qui correspondent à un élément fonctionnel du dispositif et qui peut ainsi comprendre ou correspondre à une ou plusieurs couches. Chaque niveau topologique mono ou multicouche peut être associé à un qualificatif ou plusieurs qualificatifs indiquant une propriété électrique (comme "conducteur", "diélectrique", etc.) ou optique (par exemple "transparent", "opaque") ; ou désignant un ensemble électronique fonctionnel, comme : "TFT" pour désigner l'ensemble des couches formant les transistors TFT, "organique" ou "active organique" pour désigner la ou les couches formant les jonctions PN organiques ainsi que la ou les éventuelles couches intermédiaires d'interface avec les électrodes inférieures (pixel) et supérieure (commune).

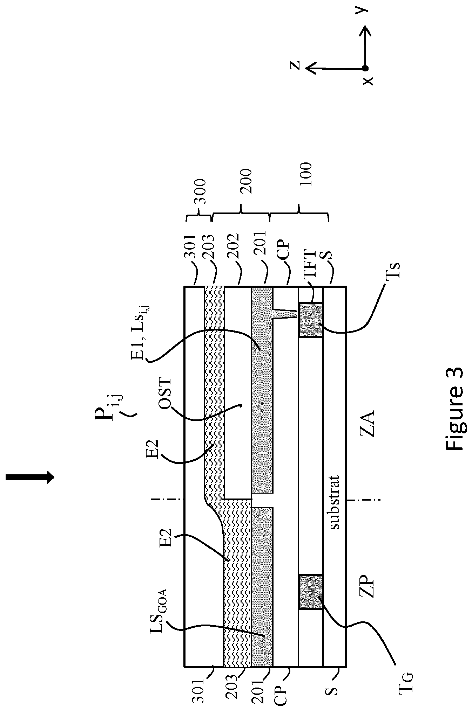

La figure 3 est une vue en coupe générale du dispositif électrooptique de la figure 2, montrant les niveaux topologiques principaux. On trouve successivement dans la zone active, et dans cet ordre, à partir de la surface supérieure d'un substrat S :
- un premier niveau d'empilement 100 qui correspond aux transistors TFT. Ce niveau réalise ainsi les transistors Tg du circuit de pilotage 20 et les transistors de pixel, Ts dans l'exemple. Ces transistors sont figurés par un pavé sans détails de leur constitution, et sont recouverts par une couche de passivation, isolante (diélectrique) CP qui forme la surface supérieure de l'empilement 100. Il peut s'agir d'une couche assez épaisse de résine, qui forme une surface bien plane pour la suite de l'empilement.
- un niveau topologique 200 correspondant à la matrice de détection et qui se décompose en un premier niveau topologique conducteur 201 pour la réalisation des électrodes inférieures E1 des pixels, sur la couche de passivation CP ; un deuxième niveau organique actif 202 qui correspond à la structure organique active OST incluant la ou les couches de jonction PN organique et la ou les couches intermédiaires d'injection de charges associées aux électrodes de jonction E1 et E2 ; et un troisième niveau topologique conducteur 203 d'électrode supérieure E2 ; puis
- un niveau topologique supérieur 300 comprenant principalement une couche 301 de passivation, pour obtenir une surface plane en face supérieure de l'empilement et qui a aussi la fonction de protéger les matériaux organiques de la structure active OST, de l'oxygène de l'air et de l'humidité.

L'empilement pourrait comprendre d'autres niveaux topologiques non représentés. Notamment, sur le niveau 300, on peut réaliser un ou des niveaux topologiques supplémentaire par exemple pour réaliser un tapis de diodes électroluminescentes pour l'éclairage ; ou encore une fonction de filtrage optique pour sélectionner une gamme de longueurs d'onde. Egalement, la structure organique active est ici présentée comme une structure continue dans la zone active, où les éléments de détection individuels sont définis dans chaque pixel par l'électrode de pixel E1. Mais elle pourrait être formée en une structure localisée spatialement avec autant de motifs que de pixels. Dans ce cas, on a généralement des niveaux topologiques supplémentaires correspondant à des couches d'arrêt (pour la réalisation des motifs) ou de blocages de charges. Ces différents aspects sont connus de l'homme de l'art. Tous ces aspects de réalisation de matrice organique de détection pour capteur d'image sont bien connus et n'ont pas à être détaillés plus, car l'invention porte sur une utilisation avantageuse des niveaux topologiques d'électrodes inférieure ou supérieure pour améliorer la fiabilité du dispositif et sa compacité.

Le niveau topologique conducteur 201 est celui correspondant à l'électrode pixel E1, qui assure une fonction électronique de collection des charges électriques (des électrons, s'agissant d'une cathode) générées par la conversion photoélectrique de photons reçus dans la jonction PN réalisée par la structure active OST entre l'électrode pixel E1 (dessous) et l'électrode supérieure E2 (dessus). Cette électrode pixel E1 est interconnectée sur le drain du transistor TFT de sélection Ts du pixel P_{i,j} par interconnexion verticale (via une ouverture ménagée dans l'épaisseur de couche(s) diélectrique(s) entre la surface de couche de passivation et le drain).

Ce niveau topologique conducteur 201 d'électrode pixel E1 est utilisé dans l'invention pour réaliser dans la zone active, des écrans optiques individuels pour le ou les transistors TFT dans chaque pixel, et dans la zone périphérique, un écran optique commun pour les transistors du circuit de pilotage. Ces écrans permettent de protéger les transistors TFT des rayonnements arrivant par les couches/niveaux supérieurs : pendant toute la suite des étapes de réalisation des niveaux topologiques supérieurs, comprenant les niveaux topologiques organiques, d'électrode supérieure et de passivation finale ; et ensuite, en opérationnel, dans le capteur d'image (lumière utile, lumière d'éclairage).

Si on reprend la figure 2 : on forme ainsi un écran individuel LS_{i,j} dans chaque pixel dans la zone active ZA qui couvre (au moins) le ou les transistors TFT du pixel ; et un écran LS_{GOA} global dans la zone périphérique ZP qui couvre l'ensemble des transistors TFT du circuit de pilotage. Cet écran LS_{GOA} sert en outre de structure d'interconnexion pour polariser l'électrode supérieure E2 des photodiodes organiques de la zone active, à la tension de polarisation Vbias, par un recouvrement en contact direct. En pratique l'électrode supérieure E2 couvre la surface de matrice de détection 10 et s'étend dans la zone périphérique, du côté du circuit de pilotage 20, sur la surface supérieure de plaque 50 d'écran LS_{GOA ;} et l'écran LS_{GOA} comporte sur un côté de plaque 50, une région en forme de doigt 51 s'étendant vers un bord du substrat pour permettre l'application de la tension externe de polarisation Vbias via des plots de reprise de contact 52.

Plus précisément, et comme visible clairement sur la vue en coupe de la figure 3, dans la zone active ZA, les deux niveaux topologiques conducteurs 201 (d'électrode pixel E1) et 203 (d'électrode supérieure E2) sont séparés par le niveau topologique 202 de structure active organique (jonction PN et/ou couches intermédiaires d'interface avec les électrodes) ; dans la zone périphérique, on retrouve ces deux niveaux topologiques 201 et 203, mais formés directement l'un sur l'autre, en contact direct, sans interposition d'autres niveaux/couches.

Cette configuration selon l'invention a de multiples avantages. D'abord, elle permet l'insertion de la fonction d'écran de lumière permettant de protéger tous les transistors TFT du composant aussi bien dans la zone périphérique que dans la zone active, sur un niveau topologique déjà existant dans le dispositif. C'est optimal en termes de compacité et de coût de fabrication. Et cette fonction d'écran est efficace à protéger les transistors TFT de la lumière arrivant par les niveaux topologiques supérieurs, tant pendant le procédé de fabrication, qu'en mode opérationnel, et ce de façon complètement indépendante de la technologie TFT utilisée. Par ailleurs, comme l'écran protégeant les transistors du circuit de pilotage n'est pas laissé flottant, mais porté à une tension fixe (la tension Vbias), on évite que des couplages électriques (capacitifs) avec l'électronique du circuit de pilotage se produisent. Cela permet également de protéger le circuit de pilotage d'éventuelles décharges électrostatiques.

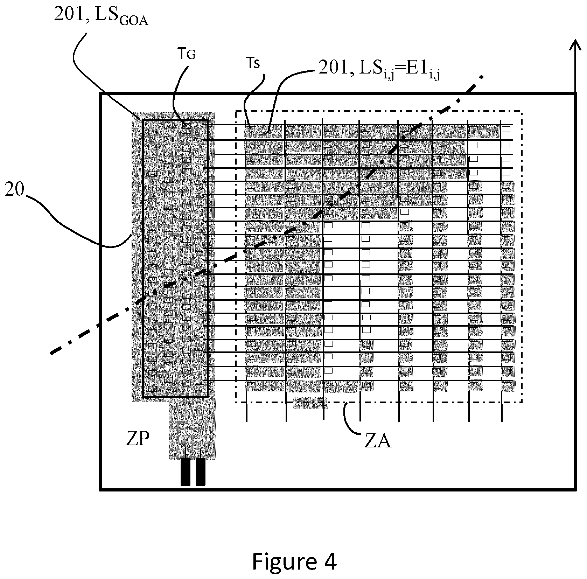

Si le dispositif est destiné à un capteur dans lequel l'éclairage et la lumière à détecter arrivent par la face avant, l'électrode supérieure doit être transparente, mais l'électrode pixel E1 peut être opaque (figures 3 et 4). Dans ce cas l'écran de pixel LS_{i,j} peut se confondre avec l'électrode pixel E1. C'est ce que représente la figure 3 : l'électrode pixel est réalisée en une structure monocouche de métal opaque sur le niveau 201 et le même motif opaque conducteur réalise la fonction électronique de collection des charges d'électrode pixel et la fonction optique d'écran individuel pour le(s) transistor(s) TFT du pixel.

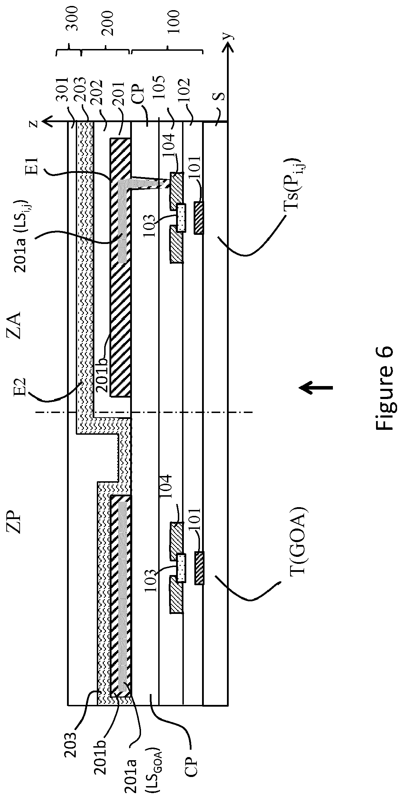

Mais si le dispositif est destiné à un capteur dans lequel l'éclairage et/ou la lumière à détecter arrivent par la face arrière, l'électrode pixel E1 doit être globalement transparente, c'est-à-dire transparente partout à l'exception d'une petite surface opaque au-dessus du (des) transistor(s), qui forme l'écran de pixel LS_{i,j}. C'est le cas représenté sur les figures 2 et 6. On réalise cela en prévoyant avantageusement une structure topologique d'électrode pixel qui est au moins bicouche opaque/transparente, permettant d'intégrer et localiser un motif opaque dans le motif d'électrode pixel. Avantageusement cette structure au moins bicouche permet de réaliser un motif d'électrode pixel opaque ou "globalement opaque" (on verra plus loin que l'électrode peut être transparente sur les bords) ; ou bien un motif d'électrode pixel "globalement transparente", c'est-à-dire transparente sauf au-dessus du ou des transistors TFT du pixel, en ajustant le dessin de masque opaque aux spécificités du produit de destination.

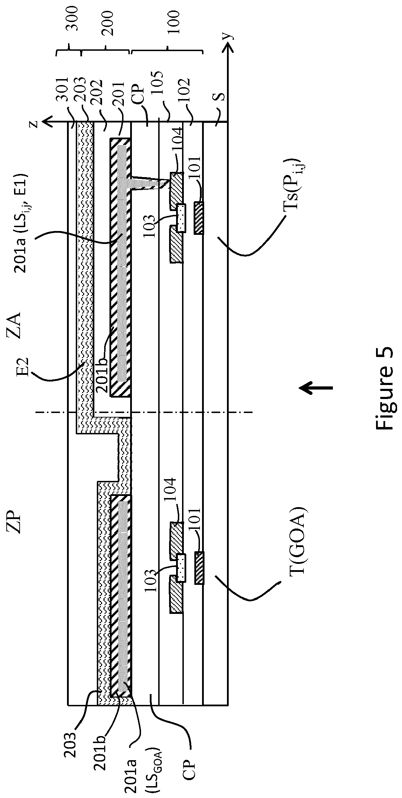

Plus précisément, on prévoit avantageusement dans l'invention un niveau topologique conducteur 201 qui est un multicouche comprenant au moins une couche conductrice transparente 201b sur une couche de métal opaque 201a. Le niveau supérieur de couche transparente 201b, est localisé spatialement pour former le motif d'électrode pixel E1 dans chaque pixel ; et le niveau inférieur de couche opaque 201a, sert à former l'écran individuel LS_{i,j} de pixel. C'est-à-dire que le niveau transparent est toujours présent, sur toute la surface d'électrode pixel, et la taille de motif du niveau opaque est ajustée en fonction des spécificités du produit, en changeant le dessin de masque associé. Ainsi :
- la surface d'écran LS_{i,j} de la figure 2 ou 6, est circonscrite à la surface "TFT" du pixel et l'électrode pixel est "globalement transparente" (la surface occupée par le(s) transistor(s) TFT est petite devant la surface d'électrode pixel). Une vue en coupe correspondante est représentée à la figure 5 ;
- la surface d'écran LS_{i,j} de la figure 3, 4 ou 5, correspond sensiblement à la surface d'électrode pixel. L'électrode pixel est alors globalement opaque. Le terme "globalement opaque" signifie que l'électrode pixel peut être entièrement opaque comme sur la figure 3 (structure monocouche en métal opaque, ou structure métal opaque/matériau transparent parfaitement alignés); ou bien ne pas être opaque sur les bords, par exemple parce que le niveau supérieur transparent, déborde un peu (comme un capot) de chaque côté du motif opaque, ou bien l'encapsule complètement comme illustré sur la figure 5, comme cela sera expliqué plus loin.

Dans les deux configurations, on applique exactement la même séquence d'étapes technologiques de fabrication du dispositif ; c'est le dessin de masque de couche opaque 201a, dans la zone active, qui est adapté pour former une électrode pixel qui sera globalement transparente ou globalement opaque, en fonction des spécificités du produit de destination.

Cette constitution est aussi avantageuse en termes de coûts et de choix des matériaux pour réaliser ce niveau topologique conducteur 201. En effet, pour le niveau conducteur supérieur 201b, on peut alors utiliser des oxydes conducteurs transparents tels que de l'ITO ou du ZnO pour réaliser la couche 201b, qui sont des matériaux conducteurs courants, peu coûteux et inoxydables et qui de manière connue ont des propriétés électroniques (affinité électronique, travail de sortie) compatibles avec les structures actives organiques réalisées au-dessus. On favorise ainsi la recollection des charges photogénérées dans la structure active, sur l'électrode inférieure (électrode pixel) E1. Et pour le niveau inférieur de couche opaque 201a, on peut utiliser des métaux couramment utilisés pour la réalisation des niveaux conducteurs de transistors TFT, par exemple mais non exhaustivement : argent, molybdène, cuivre.

En pratique, on peut par exemple réaliser le niveau conducteur 201 sur la surface supérieure de couche de passivation CP, en utilisant deux étapes successives de dépôt : un dépôt et une localisation d'une couche de matériau opaque 201a (formation des motifs d'écrans), puis un dépôt et une localisation d'une couche de matériau transparent 201b.

De préférence, le motif de couche transparente 201b déborde du motif de couche opaque 201a, tel un capot, en sorte que d'un produit à un autre, seul le dessin de masque de couche opaque doit être adapté (à la taille de la surface TFT du pixel ; à la nature globalement opaque ou transparente de l'électrode pixel). Ce débord par le matériau transparent 201b permet aussi d'améliorer l'accroche mécanique sur la couche de passivation, et de protéger le métal opaque d'une oxydation, ce qui aurait pour effet d'altérer ses propriétés de conduction électrique.

Avantageusement le motif opaque est intégré dans l'épaisseur de matériau transparent, ce qui améliore tous ces effets (accroche, non oxydation). On obtient un motif tri-couche transparent/opaque /transparent, comme représenté sur les figures 5 et 6. Pour cela, on dépose un premier niveau de couche de matériau transparent 201b ; par-dessus ce premier niveau transparent, on dépose et localise le métal opaque 201a ; puis on dépose un deuxième niveau de couche de matériau transparent 201b, puis on localise spatialement la structure multicouche obtenue pour réaliser le motif d'électrode pixel dans la zone active, et d'écran dans la zone périphérique.

Les figures 5 et 6 montrent en plus, à titre indicatif, les éléments constitutifs de grille, canal, drain et source des transistors TFT et des niveaux topologiques correspondants : conducteur 101 (grille), isolant de grille 102, semi-conducteur 103 (canal), conducteur 104 (drain/source) et diélectrique final 105 (typiquement un nitrure : SiN, SiNx, SiOx, SiON, etc.), pour un exemple de structure à grille dessous, qui est la plus favorable en termes de compacité et de mobilité électrique. La couche de passivation CP ajoutée par-dessus est généralement en matériau diélectrique organique, typiquement une résine, par exemple du SU8.

A noter qu'on pourrait aussi prévoir que la couche de passivation CP comprenne en plus d'une épaisseur de résine, une couche superficielle en matériau diélectrique inorganique, de préférence le même matériau que celui de la couche 105, pour favoriser l'accroche mécanique du métal opaque 201a. Ces différentes variantes sont couvertes par l'invention.

L'invention qui vient d'être expliquée s'applique à toutes technologies de transistors TFT, aussi bien à grille dessus que dessous. Notamment, dans les structures à grilles dessus, on sait que les grilles (métal opaque) peuvent ne pas parfaitement protéger les bords de canal, de la lumière arrivant par les niveaux supérieurs. Les écrans formés selon l'invention sur le niveau d'électrode pixel permettent alors d'obtenir la protection optique de manière fiable. Pour la lumière arrivant par le dessous, le substrat devra dans ce cas être rendu opaque au niveau des transistors ("black matrix").

S'agissant du niveau topologique conducteur 203 d'électrode supérieure, il pourra être réalisé par des matériaux pouvant être déposés par des techniques par voie liquide à faible budget thermique, et convenant pour réaliser cette électrode : des métaux tels que Al, Ag, Au et Pt en couche ultramince pour la transparence ; des oxydes conducteurs transparents tels que ITO (oxyde d'indium dopé à l'étain, IZO (oxyde de zinc dopé à l'étain)) ; un conducteur organique, tel que le PEDOT-PSS (mélange de deux polymères : le poly(3,4-éthylènedioxythiophène) (PEDOT) et le poly(styrène sulfonate) de sodium (PSS)).

Notamment il est généralement avantageux en manière de coût et de qualité de transparence (quand elle est nécessaire) d'utiliser un matériau à base de PEDOT-PSS. On peut y associer du métal, inséré sous forme de fils (fils d'argent par exemple), ou sous forme d'une grille, pour abaisser sa résistance surfacique. Dans ce cas, avec une couche 201b en oxyde conducteur transparent tel que l'ITO ou le ZnO, on bénéficie d'une bonne compatibilité électronique (travail de sortie) avec l'électrode supérieure.

A titre d'exemple, dans une réalisation pratique de l'invention, on réalise sur le niveau 201 de l'empilement un motif tri-couche transparent/opaque/transparent, avec comme matériau opaque 201a, du molybdène déposé en 200 nanomètres d'épaisseur, encapsulé dans de l'ITO (201a) avec une épaisseur d'ITO de 20 nanomètres sous le matériau opaque et de 30 nanomètres au-dessus.

## Revendications

1. Dispositif optoélectronique comportant :
dans une zone de matrice active (ZA), un agencement matriciel de pixels, chaque pixel comportant au moins un transistor (Ts) de sélection et une photodiode organique (OP) connectée audit au moins un transistor de sélection par une première électrode (E1) ;
dans une zone périphérique (ZP), des transistors (T_{G}) de pilotage de lignes de pixels ; et
un écran de lumière (LS_{GOA}) qui s'étend de manière continue au-dessus desdits transistors (T_{G}) de pilotage, et comporte une zone de reprise de contact (52) permettant une connexion à une tension de polarisation externe (Vbias), une deuxième électrode (E2), commune aux pixels, s'étendant dans la zone périphérique (ZP) et formant une interconnexion avec ladite zone de reprise de contact.

2. Dispositif selon la revendication 1, dans lequel la zone de matrice active (ZA) comporte :
un premier ensemble de couches (100) réalisant lesdits transistor de sélection (Ts), recouvert par une couche de passivation (CP), isolante et continue ; et
un deuxième ensemble de couches (200) réalisant les photodiodes organiques (OP) des pixels, porté par la couche de passivation (CP) et comprenant ledit écran de lumière (LS_{GOA}) couvrant au moins la surface de transistor (Ts) de chaque pixel.

3. Dispositif selon la revendication 2, dans lequel les transistors de pilotage (T_{G}) de la zone périphérique (ZP) sont réalisés dans le premier ensemble de couches.

4. Dispositif selon la revendication 2 ou 3, dans lequel ;
ledit deuxième ensemble de couches (200) comporte un niveau d'empilement de couche(s) (201) réalisant la première électrode (E1) de chaque pixel ; et
ledit niveau comprend au moins une couche conductrice en métal opaque (201a), spatialement localisée pour former un motif d'écran de lumière individuel dans chaque pixel dans la zone active (ZA) et un motif d'écran de lumière (LS_{GOA}) pour les transistors de pilotage (T_{G}) dans la zone périphérique (ZP).

5. Dispositif selon la revendication 4, dans lequel ledit niveau d'empilement de couche(s) (201) comprend au moins une deuxième couche en matériau conducteur transparent (201b) qui forme la surface supérieure dudit niveau d'empilement.

6. Dispositif selon l'une quelconque des revendication 2 à 5, dans lequel le deuxième ensemble de couches (200) comporte un niveau d'empilement de couche(s) conductrices (203) réalisant la deuxième électrode (E2) des pixels et s'étendant au-dessus de la structure active.

7. Dispositif selon l'une quelconque des revendications 1 à 6, dans lequel dans chaque pixel, la surface d'écran de lumière (LS_{GOA}) correspond à la surface d'électrode du pixel.

8. Dispositif selon l'une quelconque des revendications 1 à 6, dans lequel dans chaque pixel, la surface d'écran de lumière (LS_{GOA}) est circonscrite à la surface de transistor(s) dans le pixel.

9. Dispositif selon l'une des revendications 5 à 8, dans lequel ledit matériau conducteur transparent (201b) est un oxyde conducteur.

10. Dispositif optoélectronique matriciel selon l'une des revendications 6 à 9, dans lequel ledit niveau d'empilement (203) formant la deuxième électrode (E2) est à base de PEDOT-PSS.

11. Dispositif selon l'une des revendications 1 à 10, dans lequel les transistors sont réalisées dans une technologie à couche mince du groupe suivant : silicium amorphe (a-SI:H), à Oxyde d'indium-Gallium-Zinc (IGZO), organiques (OTFT), à silicium polycristallin basse température (LTPS).

12. Capteur d'image intégrant un dispositif selon l'une quelconque des revendications précédentes.
